(19)

Europäisches
Patentamt

European
Patent Office

Office européen
des brevets

(11)　EP 3 280 046 B1

(12)　　　　　　　　　**EUROPEAN PATENT SPECIFICATION**

(45) Date of publication and mention
　　 of the grant of the patent:
　　 **29.04.2020　Bulletin 2020/18**

(21) Application number: **16771303.1**

(22) Date of filing: **23.03.2016**

(51) Int Cl.:
　　 **H03D 7/16** *(2006.01)*

(86) International application number:
　　 **PCT/CN2016/077102**

(87) International publication number:
　　 **WO 2016/155548 (06.10.2016 Gazette 2016/40)**

(54) **ELECTRONIC DEVICE IN WIRELESS COMMUNICATIONS SYSTEM, WIRELESS
COMMUNICATIONS SYSTEM, AND METHOD**

ELEKTRONISCHE VORRICHTUNG IN EINEM DRAHTLOSKOMMUNIKATIONSSYSTEM,
DRAHTLOSKOMMUNIKATIONSSYSTEM UND VERFAHREN

DISPOSITIF ÉLECTRONIQUE DANS UN SYSTÈME DE COMMUNICATIONS SANS FIL, SYSTÈME
DE COMMUNICATIONS SANS FIL, ET PROCÉDÉ

(84) Designated Contracting States:
　　 **AL AT BE BG CH CY CZ DE DK EE ES FI FR GB
　　 GR HR HU IE IS IT LI LT LU LV MC MK MT NL NO
　　 PL PT RO RS SE SI SK SM TR**

(30) Priority: **30.03.2015　CN 201510146241**

(43) Date of publication of application:
　　 **07.02.2018　Bulletin 2018/06**

(73) Proprietor: **Sony Corporation
　　 Tokyo 108-0075 (JP)**

(72) Inventors:
　　 • **DANG, Jian
　　　 Nanjing
　　　 Jiangsu 210096 (CN)**
　　 • **XIANG, Nan
　　　 Nanjing
　　　 Jiangsu 210096 (CN)**

(74) Representative: **D Young & Co LLP
　　 120 Holborn
　　 London EC1N 2DY (GB)**

(56) References cited:
　　 **WO-A1-03/021859　　　CN-A- 101 233 506
　　 CN-A- 101 872 618　　　CN-A- 103 441 734
　　 US-A1- 2004 240 588**

　　 • **ROHIT DATTA ET AL: "FBMC and GFDM
　　　 Interference Cancellation Schemes for Flexible
　　　 Digital Radio PHY Design", DIGITAL SYSTEM
　　　 DESIGN (DSD), 2011 14TH EUROMICRO
　　　 CONFERENCE ON, IEEE, 31 August 2011
　　　 (2011-08-31), pages 335-339, XP032058647, DOI:
　　　 10.1109/DSD.2011.48 ISBN: 978-1-4577-1048-3**
　　 • **RITT: "Uplink Multiple Access Aspect of FDD
　　　 LTE", 3GPP DRAFT; R1-050402, 3RD
　　　 GENERATION PARTNERSHIP PROJECT (3GPP),
　　　 MOBILE COMPETENCE CENTRE ; 650, ROUTE
　　　 DES LUCIOLES ; F-06921 SOPHIA-ANTIPOLIS
　　　 CEDEX ; FRANCE, vol. RAN WG1, no. Athens,
　　　 Greece; 20050503, 3 May 2005 (2005-05-03),
　　　 XP050100098, [retrieved on 2005-05-03]**
　　 • **RAHIMI SIAVASH ET AL: "Joint Channel and
　　　 Frequency Offset Estimation for Oversampled
　　　 Perfect Reconstruction Filter Bank
　　　 Transceivers", IEEE TRANSACTIONS ON
　　　 COMMUNICATIONS, IEEE SERVICE CENTER,
　　　 PISCATAWAY, NJ. USA, vol. 62, no. 6, 1 June 2014
　　　 (2014-06-01), pages 2009-2021, XP011551346,
　　　 ISSN: 0090-6778, DOI:
　　　 10.1109/TCOMM.2014.2318717 [retrieved on
　　　 2014-06-18]**

EP 3 280 046 B1

## Description

## FIELD

The present disclosure relates to the technical field of wireless communication, and in particular to an electronic device in a wireless communication system, a wireless communication system and a method for performing wireless communication in a wireless communication system.

## BACKGROUND

This section provides background information relating to the present disclosure, which is not necessarily prior art.

A Filter Bank (FB) is a non-orthogonal multiple access technology with a good application prospect, and is a general version of the famous Orthogonal Frequency Division Multiplexing (OFDM) system. Different from OFDM, in the FB, each subband has good frequency limitation, and the spectrum of the subband only overlaps with a spectrum of a neighboring subband. Due to the characteristic, the FB has better robustness for a frequency offset than the OFDM, since inter-subband interference is only from the neighboring subband. In addition, due to the limitation of the subband spectrum of the FB, the FB has better robustness for narrow band interference than the OFDM.

Since the FB is non-orthogonal, coefficients of the FB generally needs to be designed carefully to obtain a Perfect Reconstruction (PR) characteristic so as to recover a transmitted signal. However, in an actual system, the PR characteristic cannot be maintained due to channel influence, and a receiver still needs to process the inter-subband interference. In some applications, spectrum needs to be divided non-uniformly even in a time-varying manner; in this case, the PR design will become difficult.

Prior Art Includes:

ROHIT DATTA ET AL: "FBMC and GFDM Interference Cancellation Schemes for Flexible Digital Radio PHY Design", DIGITAL SYSTEM DESIGN (DSD), 2011, 14th EUROMAICRO CONFERENCE ON, IEEE 31 August 2011, page 335-339.

RITT: "Uplink Multiple Access Aspect of DFF LTE", 3GPP DRAFT; R1-050402, 3RD GENERATION PARTNERSHIP PROJECT (3GPP), MOBILE COMPETENCE CENTRE; 650, ROUTE DES LUCIOLES; F-06921 SOPHIA-ANIPOLIS CEDEX; FRANCE, vol. RAN WG1, no. Athens, Greece; 3 May 2005.

RAHIMI SIAVASH ET AL: "Joint Channel and Frequency Offset Estimation for Oversampled Perfect Reconstruction Fitler Bank Transceivers", IEEE TRANSACTIONS ON COMMUNICATOIN, IEEE SERVICE CENTRER, PISCATAWAY, NJ. USA, vol. 62, no 6, 1 June 2014, pages 2009-2021.

## SUMMARY

This section provides a general summary of the present disclosure, and is not a comprehensive disclosure of its full scope or all of its features.

An object of the present disclosure is to provide an electronic device in a wireless communication system, a wireless communication system and a method for performing wireless communication in the wireless communication system, such that a subband filter can be designed without strictly following a PR characteristic and flexibility of an existing system can be improved, thereby solving at least one of the technical problems described above.

The invention is defined by the subject-matter of the independent claims. Preferred embodiments are defined in the dependent claims. Aspects or embodiments that do not fall under the scope of the claims are useful to understand the invention.

With the electronic device in the wireless communication system, the wireless communication system and the method for performing wireless communication in a wireless communication system according to the present disclosure, the analysis filter bank and the synthesis filter bank are arranged based on the parameters of the Non-Perfect Reconstruction filter bank, and inter-subband interference in each path of subband signal is eliminated based on each path of subband signal and its neighboring subband signal. In this way, any filter design method can be used to design a filter without strictly following the perfect reconstruction characteristic, as long as a requirement of frequency band dividing is met, thereby greatly improving design flexibility of the wireless communication system.

Further areas of applicability will become apparent from the description provided herein. The description and specific examples in this summary are intended for purposes of illustration only and are not intended to limit the scope of the present disclosure.

**BRIEF DESCRIPTION OF THE DRAWINGS**

The drawings described herein are for illustrative purposes only of selected embodiments and not all possible implementations, and are not intended to limit the scope of the present disclosure. In the drawings:

Figure 1 shows a block diagram of a structure of an electronic device in a wireless communication system according to an embodiment of the present disclosure;

Figure 2 shows a block diagram of a structure of an interference eliminating unit included in an electronic device in a wireless communication system according to an embodiment of the present disclosure;

Figure 3 shows a block diagram of a structure of an electronic device in a wireless communication system according to another embodiment of the present disclosure;

Figure 4(a) and Figure 4(b) show a diagram of a structure of a wireless communication system according to an embodiment of the present disclosure;

Figure 5 is a sequence diagram of a method for performing wireless communication in a wireless communication system according to an embodiment of the present disclosure;

Figure 6 shows a sequence diagram of a method for performing wireless communication in a wireless communication system according to another embodiment of the present disclosure;

Figure 7 shows a sequence diagram of a method for performing wireless communication in a wireless communication system according to another embodiment of the present disclosure;

Figure 8 shows a sequence diagram of a method for performing wireless communication in a wireless communication system according to another embodiment of the present disclosure;

Figure 9 shows a curve of a bit error rate obtained by the method for performing wireless communication in a wireless communication system according to an embodiment of the present disclosure;

Figure 10 shows a curve of a bit error rate obtained by the method for performing wireless communication in a wireless communication system according to another embodiment of the present disclosure;

Figure 11 shows a curve of a bit error rate obtained by the method for performing wireless communication in a wireless communication system according to another embodiment of the present disclosure;

Figure 12 shows a flowchart of a method for performing wireless communication in a wireless communication system according to an embodiment of the present disclosure;

Figure 13 shows a flowchart of a method for performing wireless communication in a wireless communication system according to another embodiment of the present disclosure; and

Figure 14 shows a block diagram of a schematic structure of a general-purpose personal computer which may implement the method for performing wireless communication in the wireless communication system according to the embodiment of the present disclosure.

While the present disclosure is susceptible to various modifications and alternative forms, specific embodiments thereof have been shown by way of example in the drawings and are herein described in detail. It should be understood, however, that the description herein of specific embodiments is not intended to limit the present disclosure to the particular forms disclosed, but on the contrary, the intention is to cover all modifications, equivalents, and alternatives falling within the scope of the appended claims. Note that corresponding reference numerals indicate corresponding parts throughout the several views of the drawings.

**DETAILED DESCRIPTION OF EMBODIMENTS**

Examples of the present disclosure will now be described more fully with reference to the accompanying drawings. The following description is merely exemplary in nature and is not intended to limit the present disclosure, application, or uses.

Example embodiments are provided so that this disclosure will be thorough, and will fully convey the scope to those skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms and that neither should be construed to limit the scope of the disclosure. In some example embodiments, well-known processes, well-known device structures, and well-known technologies are not described in detail.

A User Equipment (UE) involved in the present disclosure includes but not limited to terminals with a wireless communication function, such as a mobile terminal, a computer and a vehicle-mounted device. In addition, the UE involved in the present disclosure may be the UE itself or components in the UE, such as a chip. A base station involved in the present disclosure may be an evolution Node Base Station (eNB) or components in the eNB, such as a chip.

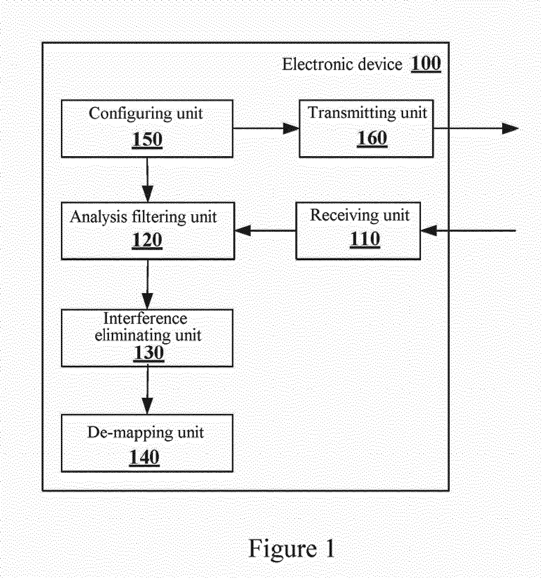

Figure 1 shows a structure of an electronic device 100 in a wireless communication system according to an embodiment of the present disclosure.

As shown in Figure 1, the electronic device 100 in the wireless communication system according to the embodiment of the present disclosure may include: a receiving unit 110, an analysis filtering unit 120 and an interference eliminating unit 130 and so on.

The receiving unit 110 may receive a signal from other electronic device in the wireless communication system.

The analysis filtering unit 120 may arrange an analysis Filter Bank (FB) based on parameters of a Non-Perfect Reconstruction (NPR) FB, decompose the signal received by the receiving unit 110 into multiple paths of subband signals by using the analysis FB and perform analysis filtering.

For each of subband signal among the multiple paths of subband signals, the interference eliminating unit 130 may eliminate inter-subband interference in each of subband signal based on each path of subband signal and its neighboring subband signal.

It should be described that, the signal received from other electronic device in the wireless communication system by the receiving unit 110 is a signal on which synthesis filtering and multiplexing are performed by a synthesis FB corresponding to the analysis FB in the analysis filtering unit 120. The synthesis FB is also arranged based on the parameters of NPR FB.

With the electronic device 100 according to the embodiment of the present disclosure, the used FB only needs to meet a frequency band dividing requirement and a subband overlapping design requirement, and a filter can be designed without meeting a Perfect Reconstruction (PR) characteristic of the conventional FB, thereby greatly improving design flexibility of the wireless communication system. However, the inter-subband interference is introduced at the receiving end artificially.

It should be noted that, for a certain path of subband signal, since the inter-subband interference caused by the NPR design only relates to the path of subband signal and its neighboring subband signal, a subband transmission signal can be detected subsequently when the inter-subband interference in each path of subband signal is eliminated by the interference eliminating unit 130.

It should be further noted that, various units involved in the specification and appended claims may be physical entities or logic entities. Units with different names may be implemented by a same physical entity.

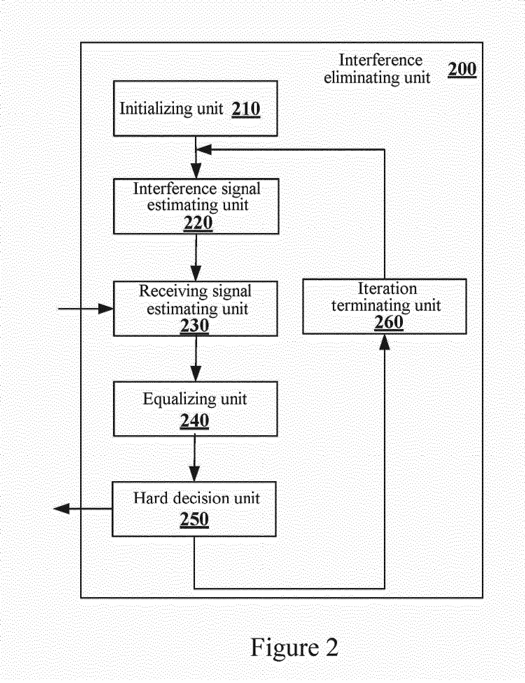

According to preferred embodiments of the present disclosure, the interference eliminating unit 130 may eliminate inter-subband interference in each path of subband signal in an iterative manner, in addition to other manners known by those skilled in the art. Hereinafter it is described in detail with reference to Figure 2.

Figure 2 shows a structure of an interference eliminating unit 200 included in an electronic device in a wireless communication system according to an embodiment of the present disclosure. The interference eliminating unit 200 shown in Figure 2 corresponds to the interference eliminating unit 130 shown in Figure 1.

As shown in Figure 2, the interference eliminating unit 200 may include an initializing unit 210, an interference signal estimating unit 220, a receiving signal estimating unit 230, an equalizing unit 240, a hard decision unit 250 and an iteration terminating unit 260.

The initializing unit 210 may initialize each path of estimated subband signal and the number of times of iterations. Particularly, the initializing unit 210 may initialize each path of estimated subband signal and the number of times of iterations into zero.

The interference signal estimating unit 220 may estimate an interference signal for each path of subband signal based on a neighboring subband signal of each path of subband signal estimated during a last time of iteration.

The receiving signal estimating unit 230 may estimate each path of subband signal after interference elimination based on the interference signal for each path of subband signal estimated by the interference signal estimating unit 220. Specifically, the receiving signal estimating unit 230 can obtain the signal after interference elimination by subtracting interference signal from the received signal.

The equalizing unit 240 may perform single-subband equalization on each path of subband signal after interference elimination to obtain each path of equalized subband signal. The equalizing unit with an equalizing function may adopt any existing equalizer, which is not limited in the present disclosure.

The hard decision unit 250 may perform hard decision on each path of equalized subband signal to obtain each path of subband signal estimated during a current time of iteration. Similarly, the hard decision unit with a hard decision function may adopt any existing hard decision device, which is not limited in the present disclosure.

When the number of times of iterations reaches a predetermined value, the iteration terminating unit 260 may stop iterations. According to a preferred embodiment of the present disclosure, the iteration terminating unit 260 may terminate iterations when the number of times of iterations reaches two. In the other aspect, when the number of times of iterations does not reach the predetermined value, an output signal obtained by the hard decision unit 250 may be provided to the interference signal estimating unit 220, to obtain a neighboring subband signal of each path of subband signal estimated by a last time of iteration.

A Single-Subband Equalization with Iterative Interference Cancellation (SSE-IIC) algorithm (which will be further described in detail hereinafter) may be performed by the interference eliminating unit 200 shown in Figure 2, thereby obtaining the subband transmission signal finally.

Refer to Figure 1 again, according to the embodiment of the present disclosure, the electronic device 100 may further include a de-mapping unit 140. The de-mapping unit 140 may de-map the signal outputted from the interference eliminating unit 130 to obtain an estimated bit stream. Similarly, the de-mapping unit with a de-mapping function may adopt any existing de-mapper, which is not limited in the present disclosure.

According to an embodiment of the present disclosure, as shown in Figure 1, the electronic device 100 may further include a configuring unit 150 and a transmitting unit 160.

The configuring unit 150 may configure parameters of the NPR FB based on a frequency band division requirement and/or a subband overlapping design requirement. Specifically, the parameters of the NPR FB configured by the configuring unit 150 may include: the number of subbands, a length of a filter, a center frequency of a subband and a bandwidth of a subband. In addition, the parameters of the NPR FB configured by the configuring unit 150 may include at least one of a transition band control factor, a ratio of a passband error to a stopband error, a passband offset, a stopband error and an error tolerance.

The transmitting unit 160 may transmit at least a part of the parameters of the NPR FB configured by the configuring unit 150 to other electronic device in the wireless communication system. In this way, the other electronic device can arrange the synthesis FB by using the received parameters of the NPR FB, to process a signal at the transmitting end.

According to the embodiment of the present disclosure, the receiving unit 110 may receive a signal containing response information from the other electronic device in the wireless communication system. The response information is information on an equivalent channel impulse response of each path of subband among multiple paths of subbands and an equivalent channel impulse response of a neighboring subband of each path of subband for each path of subband.

The interference eliminating unit 130 may eliminate the inter-subband interference in each path of subband signal based on each path of subband signal and its neighboring subband signal, by using the equivalent channel impulse response of each path of subband among the multiple paths of subbands and the equivalent channel impulse response of the neighboring subband of each path of subband for each path of subband which are obtained by the receiving unit 110.

According to the embodiment of the present disclosure, for each of the subbands, the configuring unit 150 may adjust a passband cut-off frequency and a stopband cut-off frequency dynamically, so as to maximize the following target function F:

$$F = B \log_2(1 + SINR),$$

in which, B indicates a bandwidth of an equivalent channel of each of the subbands, and SINR indicates a signal-to-interference-plus-noise ratio of each of the subbands.

In this way, the configuring unit 150 can perform a prototype filter design with optimum subband overlapping.

According to the embodiment of the present disclosure, the configuring unit 150 may configure parameters of the NPR FB, when the receiving unit 110 receives a data transmission request from the other electronic device in the wireless communication system or during the data transmission performed by the electronic device 100 with the other electronic device in the wireless communication system. In other words, the configuring unit 150 may flexibly configure the parameters of the NPR FB in time, thereby further improving design flexibility of the wireless communication system.

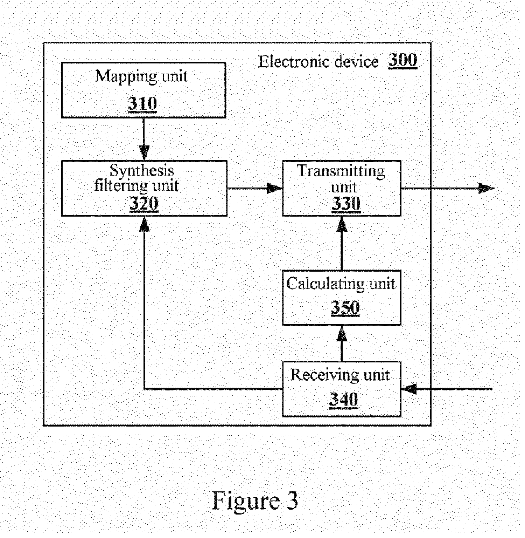

The structure of the receiving end of the wireless communication system according to the present disclosure is described with reference to Figure 1 and Figure 2 above, and subsequently a structure of a transmitting end of the wireless communication system according to the present disclosure is described with reference to Figure 3. Figure 3 shows a structure of an electronic device 300 in a wireless communication system according to another embodiment of the present disclosure.

As shown in Figure 3, the electronic device 300 as the transmitting end may include: a mapping unit 310, a synthesis filtering unit 320 and a transmitting unit 320 and so on.

The mapping unit 310 may map multiple bit streams into multiple complex symbol streams. Preferably, the bit stream is a bit stream having been subjected to channel encoding or a bit stream having not been subjected to channel encoding. In other words, the electronic device 300 may directly process a complex signal without being subjected to any pre-processing. Since the input signal may be a direct complex symbol sequence, the signal processing is simpler.

The synthesis filtering unit 320 may be communicatively connected to the mapping unit 310, and may arrange a synthesis FB based on parameters of an NPR FB and perform synthesis filtering and multiplexing on the multiple complex symbol streams mapped by the mapping unit 310, using the synthesis FB.

The transmitting unit 330 may transmit a signal outputted from the synthesis filtering unit 320 to other electronic device in the wireless communication system.

Similarly, with the electronic device 300 according to the embodiment of the present disclosure, the used FB only needs to meet a frequency band dividing requirement and a subband overlapping design requirement, and a filter can be designed without meeting a PR characteristic of the conventional FB, thereby greatly improving design flexibility of the wireless communication system.

According to the embodiment of the present disclosure, as shown in Figure 3, the electronic device 300 may further include a receiving unit 340. The receiving unit 340 may receive parameters of the NPR FB from other electronic device in the wireless communication system.

Further, according to the embodiment of the present disclosure, the electronic device 300 may further include a calculating unit 350. The calculating unit 350 may calculate, using the parameters of the NPR FB, an equivalent channel impulse response of each path of subband among multiple paths of subbands and an equivalent channel impulse response of a neighboring subband of each path of subband for each path of subband.

In this way, the transmitting unit 330 may transmit a signal containing response information to the other electronic device in the wireless communication system. The response information is information on the equivalent channel impulse response of each path of subband among the multiple paths of subbands and the equivalent channel impulse response of the neighboring subband of each path of subband for each path of subband.

According to the embodiment of the present disclosure, the wireless communication system may include both the electronic device 100 shown in Figure 1 as the receiving end and the electronic device 300 shown in Figure 3 as the transmitting end.

Preferably, the electronic device 100 may be a base station device and the electronic device 300 may be a user equipment, which is not limited in the present disclosure. For example, the electronic device 100 may be a user equipment and the electronic device 300 may be a base station device.

It should be noted that, before transmitting a signal, the transmitting end may transmit a predetermined training sequence to the receiving end firstly, so as to estimate a current channel condition by the receiving end. After the transmitting end adds front-end information to the predetermined training sequence and performs filter processing based on related parameters (for example, parameters of a prototype filter, a length of a data block, parameters of a synthesis filter bank, and a length of the front-end information and so on), the transmitting end transmits the processed training sequence to the receiving end, so as to estimate the current channel condition based on the received training sequence by the receiving end. Specifically, in a case that the channel condition is good, for example, if the SINR is greater than a predetermined threshold, the transmitting end may be instructed to use a non-front-end information mode to obtain a higher spectrum efficiency; in a case that the channel condition is not good, for example the SINR is less than or equal to the predetermined threshold, the transmitting end may be instructed to use a front-end information mode to ensure performances of the receiving end.

Specifically, as an example, the receiving end may calculate SINRs of subbands based on the received predetermined training sequence, and compare a minimum value among the SINRs of all subbands with a predetermined threshold. If the minimum value is greater than the predetermined threshold, it is indicated that a channel quality is good, and thus the transmitting end may transmit a signal without adding the front-end information to obtain a higher spectrum efficiency. In contrast, if the minimum value is equal to or less than the predetermined threshold, it is indicated that the channel quality is poor, and thus the transmitting end needs to add the front-end information in a case of transmitting a signal, to ensure performances of the receiving end. It should be understood that, the method for estimating a channel described here is only schematic, and those skilled in the art may estimate a channel by using other methods well-known in the art. For example, a channel condition may be determined based on an average value rather than a minimum value of SINRs of all the subbands, or a channel condition may be estimated based on a reference signal receiving power (RSRP), a reference signal receiving quality (RSRQ) and a channel quality indicator (CQI) and so on.

Whether the transmitting end uses a non-front-end information mode or a front-end information mode, the wireless communication system according to the present disclosure can operate normally and achieve a corresponding technical effect.

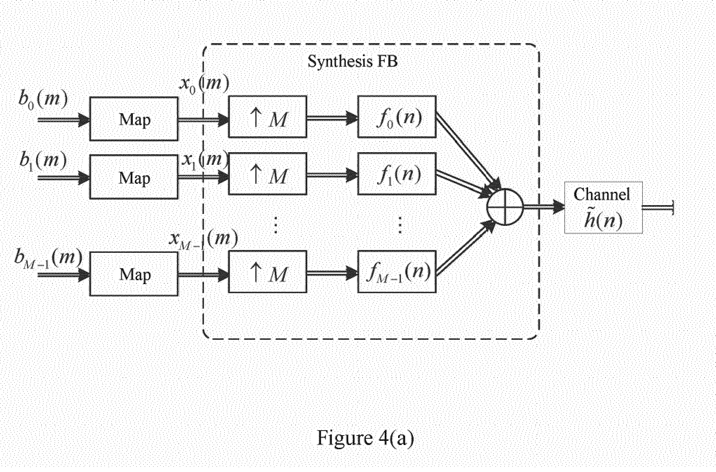

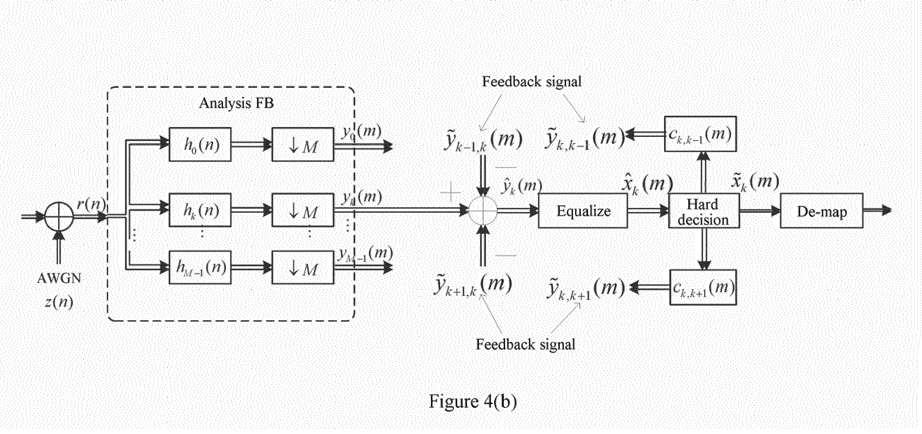

The structure of the electronic device in the wireless communication system according to the present disclosure is described summarily with reference to Figure 1 to Figure 3 above. Subsequently a specific operation of the wireless communication system according to the present disclosure is further described in detail in conjunction with Figure 4(a) and Figure 4(b).

Figure 4(a) shows specific operations of a transmitting end of the wireless communication system according to the embodiment of the present disclosure, and Figure 4(b) shows specific operations of a receiving end of the wireless communication system according to the embodiment of the present disclosure.

As shown in Figure 4(a), at the transmitting end, M bit streams $b_k(m)$ (k=0, 1, ..., M-1) which have been subjected to channel encoding or have not been subjected to channel encoding are mapped to M complex symbol streams $x_k(m)$ (k=0, 1, ..., M-1). The complex symbol streams $x_k(m)$ are transmitted by multiplexing through a synthesis FB.

Specifically, a synthesis filter for each subband is indicated as $f_k(m)$ ((k=0, 1, ..., M-1), and a corresponding up-sampling coefficient is M. A signal $x_k(m)$ from an input terminal of a synthesis filter for each subband is subjected to M multiples up-sampling, then passes through the synthesis filter $f_k(m)$, and finally M paths of signals are added to synthesize into one path of signal.

The path of synthesis signal outputted from the synthesis FB is transmitted to a channel for transmission. Here a channel impulse response is indicated as $\tilde{h}(n)$. The synthesis signal is also influenced by a channel noise z(n) (see Figure 4(b)).

As compared with the conventional filter with the PR characteristic, the synthesis filter described above has the following differences. Firstly, it does not need to combine the synthesis filter with the analysis filter to perform complex design so as to meet the perfect construction characteristic. Secondly, the FB system here may directly process a complex signal without being subjected to any pre-processing. Therefore, the synthesis filter described above may have the following beneficial effects. Firstly, as compared with the conventional filter with the PR performance, design of the filter bank in the present disclosure only needs to meet a frequency band dividing requirement and a subband overlapping design requirement, design difficulty is reduced greatly, a non-uniform or dynamic frequency band division may be used according to an actual application, and spectrum usage is more flexible compared with the PR design. Secondly, it is known for the inventor of the present disclosure that, an input signal is required to be a real number in an exponential modulated filter bank meeting a PR condition, and a real part and an imaginary part of the input complex signal need to be processed separately in an offset QAM filter bank meeting a PR condition. In contrast, in the communication system based on a non-perfect construction filter bank according to the present disclosure, the input signal may be a direct complex symbol sequence, therefore the signal processing is simpler.

As shown in Figure 4(b), at the receiving end, a received signal r(n) is firstly decomposed into M paths of subband signals by an analysis FB.

Specifically, an analysis filter for each subband is indicated as $h_k(n)$ (k=0, 1, ..., M-1), and a down-sampling coefficient for each subband is M. A signal from an input terminal of each path of analysis filter passes through the analysis filter $h_k(n)$, and is subjected to M multiples of down-sampling to obtain an output signal $y_k(m)$ (k=0, 1, ..., M-1) of each path of analysis filter.

For an output signal $y_k(m)$ (k=0, 1, ..., M-1) of a certain path of analysis filter, due to inter-subband interference caused by the non-perfect construction design, $y_k(m)$ is not only related to $x_k(m)$, but also related to transmission signals $x_{k-1}(m)$ and $x_{k+1}(m)$ of two neighboring subbands. In order to indicate a relationship between input signals and output signals conveniently, an equivalent channel impulse response for an i-th input subband to a k-th output subband is indicated as $c_{k,i}(m)$, the following equation may be obtained:

$$c_{k,i}\left(m\right) = \left[ f_i\left(n\right) * \tilde{h}\left(n\right) * h_k\left(n\right) \right]_{\downarrow M}.$$

In which, * indicates linear convolution, $\downarrow M$ indicates performing M multiples down-sampling. An expression of a signal $y_k(m)$ after down-sampling may be calculated as:

$$y_k\left(m\right) = c_{k,k}\left(m\right) * x_k\left(m\right) + c_{k,k-1}\left(m\right) * x_{k-1}\left(m\right) + c_{k,k+1}\left(m\right) * x_{k+1}\left(m\right) + \tilde{z}_k\left(m\right),$$

in which, $\tilde{z}_k(m)$ indicates an equivalent channel noise after subband filtering and down-sampling. Further, $y_k(m)$ may be expressed as:

$$y_k\left(m\right) = c_{k,k}\left(m\right) * x_k\left(m\right) + I_k\left(m\right) + \tilde{z}_k\left(m\right),$$

in which, $I_k(m) = c_{k,k-1}(m)*x_{k-1}(m)+c_{k,k+1}(m)*x_{k+1}(m)$, indicates interference from neighboring subbands, i.e., a (k-1)-th subband and a (k+1)-th subband.

According to a model of the above output signal, transmission signals of subbands may be detected using the following algorithm. For output $y_k(m)$ (k=0, 1, ..., M-1) of each path of analysis filter bank, it is detected using the SSE-IIC algorithm to obtain estimation $\hat{x}_k(m)$ of a modulated signal, hard decision is performed on $\hat{x}_k(m)$, and finally symbols are de-mapped to obtain estimated transmission bits.

Specifically, the SSE-IIC algorithm may have the following steps.

In step 1, initializing: the hard decision of symbols is set as 0, that is, $\hat{x}_k(m)$=0 (k=0, 1, ..., M-1, M=0, 1, ...); and the number of time of iterations is set as 0, i.e., it=0.

In step 2, increasing the number of times of iterations, it= it+1.

In step 3, for each subband k (k=0, 1, ..., M-1), the following operations are performed:

1) an interference signal $I_k(m)$ for a k-th subband is estimated by using the data symbol estimated during a last time of iteration;

$$\tilde{I}_k\left(m\right) = c_{k,k-1}\left(m\right) * \tilde{x}_{k-1}\left(m\right) + c_{k,k+1}\left(m\right) * \tilde{x}_{k+1}\left(m\right),$$

2) the interference signal is subtracted from the received signal;

$$\hat{y}_k\left(m\right) = y_k\left(m\right) - \tilde{I}_k\left(m\right)$$

3) a single-subband equalization is performed on the signal after interference elimination $\hat{y}_k(m)$ to eliminate influence from $c_{k, k}(m)$, to obtain estimation of $x_k(m)$, $\hat{x}_k(m)$; and

Hard decision is performed on $\hat{x}_k(m)$ to obtain $\tilde{x}_k(m)$.

In step 4, the number of times of iterations is checked; step 5 is performed if the number of times of iterations reaches a predetermined value; and the method returns to step 2 if the number of times of iterations does not reach the predetermined value.

In step 5, $\tilde{x}_k(m)$ is de-mapped to obtain bit estimation $\hat{b}_k(m)$.

With the SSE-IIC algorithm described above, inter-subband interference can be eliminated at the receiving end, thereby detecting subband transmission signals.

According to a preferred embodiment of the present disclosure, a prototype filter design method with an optimum subband overlapping design may be further provided. Specifically, a passband cut-off frequency $\omega_p$ and a stop-band cut-off frequency $\omega_s$ ($\omega_p \leq \omega_s$) of the prototype filter may be adjusted dynamically to maximize a target function F = Blog$_2$(1 + SINR). In which, B is a 3dB width of an equivalent impulse response $c_{k,k}(m)$, and

$$SINR = P_s \sum_m \left|c_{k,k}\left(m\right)\right|^2 / (P_s \sum_m \left|c_{k,k-1}\left(m\right)\right|^2 + P_s \sum_m \left|c_{k,k+1}\left(m\right)\right|^2 + \sigma_n^2 \sum_n \left|h_k\left(n\right)\right|^2)$$ indicates an SINR of a k-th subband. $C_{k,k}(m)$ indicates an equivalent channel impulse response for a k-th input subband to a k-th output subband, where k may be any value of 1 to M. $c_{k,k-1}(m)$ indicates an equivalent channel impulse response for a (k-1)-th input subband to a k-th output subband, $c_{k,k+1}(m)$ indicates an equivalent channel impulse response for a (k+1)-th input subband to a k-th output subband, and $\sigma_n^2$ indicates a noise variance.

The communication system based on the non-perfect construction filter bank and the subband signal detection method thereof are described above. It should be noted that, in order to achieve the system and method, a signaling interaction process is needed. By taking a Time Division Duplex (TDD) uplink data transmission system as an example, hereinafter the signaling interaction process is described briefly.

Firstly, a user terminal transmits a data connection request for example.

Subsequently, when a base station end agrees, the base station end distributes a filter bank with certain parameters to the user terminal and transmits a response request.

Next, the user terminal respectively calculates, based on the received parameters of the filter bank, equivalent channel impulse responses $c_{k,k}(m)$, $c_{k, k-1}(m)$ and $c_{k, k+1}(m)$ between a k-th input subband and two neighboring input subbands, i.e., a (k-1)-th input subband and a (k+1)-th input subband, to a k-th output subband, in which,

$c_{k,i}(m)=[f_i(n)^*\tilde{h}(n)^*h_k(n)]_{\downarrow M}$, $k = 0,1,\cdots,M\text{-}1$, $i=k,k\pm1$, and transmits the calculated equivalent channel impulse responses to the base station end.

Next, the user terminal performs uplink data transmission.

Lastly, based on the received equivalent channel impulse responses, the base station end processes the received data using the SSE-IIC algorithm according to the present disclosure and transmits downlink data according to requirements.

During the above signaling interaction process, a larger number of signaling data only relates to a small data amount and may be transmitted by a control channel. Only in a case that an amount of data to be transmitted is great, the data is transmitted by a data channel.

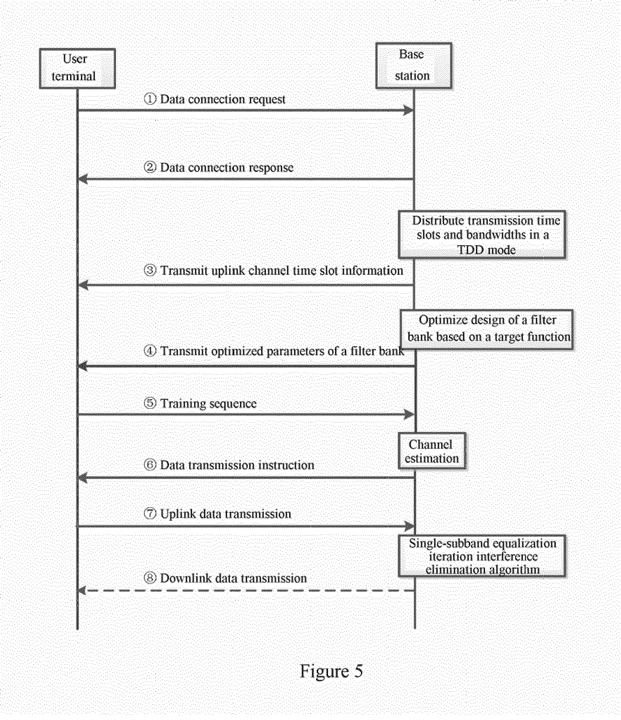

The signaling interaction process according to the present disclosure is described in detail in conjunction with Figure 5 to Figure 8.

Figure 5 shows a flowchart of a non-perfect construction filter bank system and subband signal detection method thereof in a TDD mode and in a mode of generating a synthesis FB by a base station end according to an embodiment of the present disclosure.

In order to achieve a communication system based on a non-perfect construction filter bank and multiple-subband equalization signal detection method thereof, a signaling interaction process is needed. For TDD, uplink and downlink communication between the base station end and the user terminal is performed by using different time slots of a same frequency channel, and an uplink channel and a downlink channel are separated based on time.

For the TDD uplink data transmission system and the mode of generating the synthesis FB by a base station end shown in Figure 5, the involved signaling is shown in table 1. In table 1, the involved channels include a Physical Uplink Share Channel (PUSCH), a Physical Uplink Control Channel (PUCCH), a Physical Downlink Share Channel (PDSCH) and a Physical Downlink Control Channel (PDCCH).

Table 1 signaling included in a signaling interaction process in a TDD mode and a mode of generating the synthesis FB by a base station end

| Signaling | Physical channel passed | direction |
| --- | --- | --- |
| data connection request | PUCCH | user terminal→base station |
| data connection response | PDCCH | base station→user terminal |
| transmit uplink channel time slot information | PDCCH | base station→user terminal |
| transmit optimized parameters of a filter bank | PDCCH | base station→user terminal |
| training sequence | PUSCH | user terminal→base station |
| data transmission instruction | PDCCH | base station→user terminal |
| uplink data transmission | PUSCH | user terminals→base station |
| downlink data transmission | PDSCH | base stations→user terminal |

As shown in Figure 5, in step 1, the user terminal transmits a data connection request.

In step 2, when the base station end receives the request from the user terminal, the base station end transmits a response request if communication is allowed in a current condition.

In step 3, the base station end determines available frequency resources in the TDD mode as a physical share channel, distributes different time slots of the channel for uplink and downlink data transmission, distributes a certain bandwidth to user terminals based on requirements of the user terminals, designs a prototype filter by using a prototype filter optimizing design method according to the present disclosure and generates a synthesis filter bank and an analysis filter bank. Parameters required in a case of designing the prototype filter are shown in table 2.

Table 2 related parameters of a filter bank

| parameter name | parameter description |
| --- | --- |
| the number of subbands M | M channels of FBMC, M is generally an even number, corresponding to M synthesis filters and M analysis filters |
| a length of a filter Nf | the length of the filter is generally an integral times of the number of subbands M |

(continued)

| parameter name | parameter description |
|---|---|
| Subband center frequency | frequency band parameter distributed to each user |
| Subband bandwidth | frequency band parameter distributed to each user |
| transition band control factor | design for controlling the transition band in the filter bank |
| a ratio of a passband error to a stopband error | design for controlling passband and stopband errors comprehensively in the filter bank |
| passband offset | design for controlling the passband in the filer bank |
| stopband offset | design for controlling the stopband in the filter bank |
| error tolerance | design for controlling an allowable range of errors in the filter bank |

Subsequently, the base station transmits uplink channel time slot distribution information and optimized synthesis filter bank information to all the user terminals. For parameter information related to the synthesis filter bank, in a case of uniformly dividing the frequency band, in addition to transmitting a subband center frequency to different user terminals, only one prototype filter is to be transmitted to all user terminals, and different user terminals may obtain corresponding synthesis filters by frequency transition, thereby saving signaling overhead. In a case of not dividing the frequency band uniformly, different synthesis filters are to be directly transmitted to different user terminals.

In step 4, the base station end transmits the optimized filter bank parameters to the user terminal.

In step 5, the user terminal transmits a training sequence to the base station end.

In step 6, the base station end performs channel estimation based on the received training sequence, and transmits the data transmission instruction to the user terminal.

In step 7, the user terminal performs uplink data transmission in the distributed time slot after receiving a data transmission instruction.

In step 8, the base station end processes the received data by performing the SSE-IIC algorithm according to the present disclosure, and transmits downlink data according to requirements.

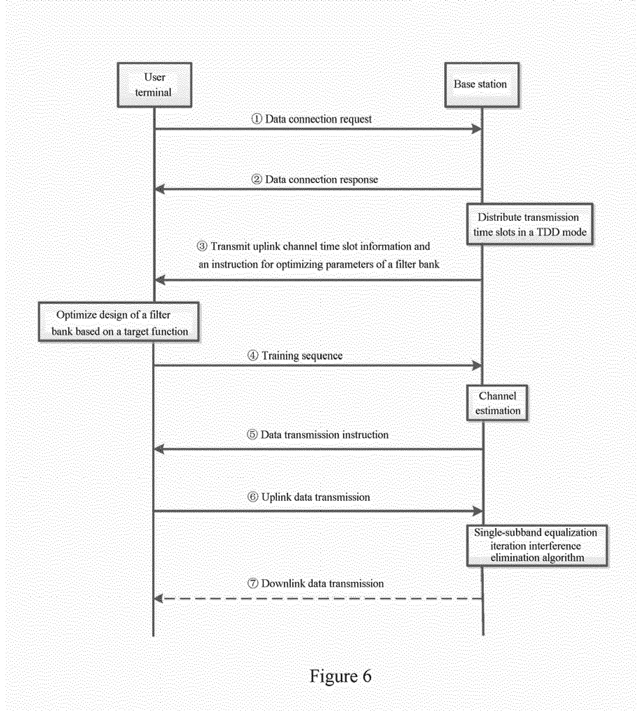

Figure 6 shows a flowchart of signaling interaction of a non-perfect construction filter bank system and subband signal detection method thereof in a TDD mode and a mode of generating a synthesis FB by a user terminal according to an embodiment of the present disclosure. The flowchart shown in Figure 6 is substantially similar to the flowchart shown in Figure 5, and the same steps in Figure 6 and Figure 5 are not repeated here for briefness.

Different from Figure 5, in a time division duplex uplink data transmission system shown in Figure 6, a synthesis filter bank is generated by a user terminal rather than a base station end.

As shown in Figure 6, in step 3, the base station end determines available frequency resources in the TDD mode as a physical share channel, distributes different time slots of the channel for uplink and downlink transmission, and distributes a certain bandwidth to users based on requirements of the user terminals. Then, the base station end transmits uplink channel time slot distribution information and parameter information related to design of a prototype filter to all user terminals. In addition to a center frequency and a subband bandwidth, other parameters for the design of the prototype filter are the same for all users.

Subsequently, in step 4, the user terminals optimize design of corresponding synthesis filters based on a received parameter optimizing instruction, to generate a synthesis filter bank, and transmit a training sequence to the base station end.

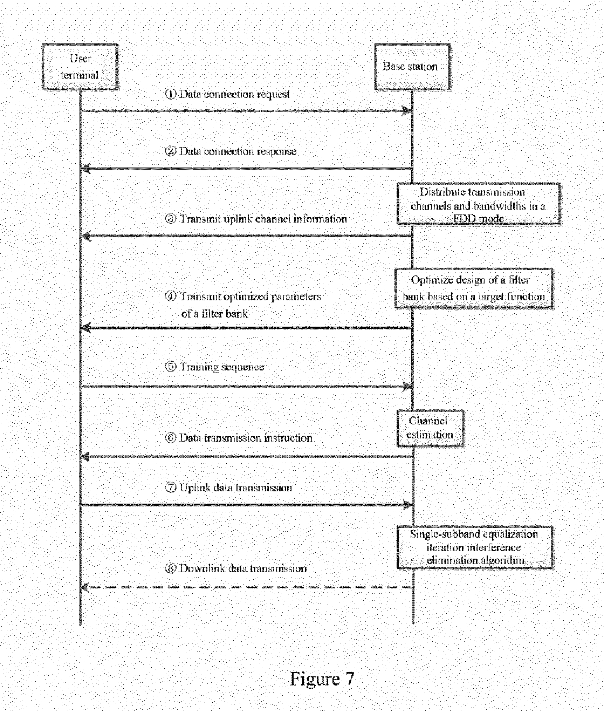

Figure 7 shows a flowchart of signaling interaction of a non-perfect construction filter bank and subband signal detection method thereof in a Frequency Division Duplexing (FDD) mode and a mode of generating a synthesis FB by a base station end according to an embodiment of the present disclosure.

For the FDD, uplink and downlink communication between the base station end and the user terminal are performed on two separated frequency channels, the base station end transmits a signal to the user terminal via a channel with a frequency, and the user terminal transmits a signal to base station end by a channel with another frequency. The flowchart shown in Figure 7 is substantially similar to the flowchart shown in Figure 5, and the same steps in Figure 7 and Figure 5 are not repeated here for briefness.

As shown in Figure 7, in step 3, the base station end determines two certain channels with different frequencies in the FDD mode to function as a physical uplink share channel and a physical downlink share channel respectively, distributes a certain bandwidth to users based on requirements of the user terminals, designs a prototype filter by using a prototype filter optimizing design method according to the present disclosure, and generates a synthesis filter bank and an analysis filter bank.

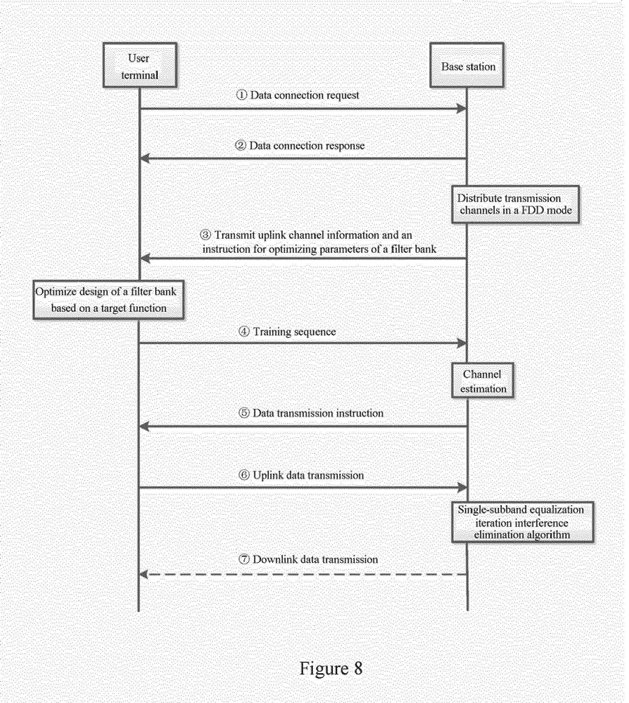

Figure 8 shows a flowchart of signaling interaction of a non-perfect reconstruction filter bank system and subband signal detection method thereof in a FDD mode and a mode of generating a synthesis FB by a user terminal according to an embodiment of the present disclosure. The flowchart shown in Figure 8 is substantially similar to the flowchart shown in Figure 7. The same steps in Figure 8 and Figure 7 are not repeated here for briefness.

Different from Figure 7, in the frequency division duplexing uplink data transmission system shown in Figure 8, a synthesis filter bank is generated by a user terminal rather than a base station end.

As shown in Figure 8, in step 3, the base station determines two channels with different frequencies in the FDD mode to function as a physical uplink share channel and a physical downlink share channel respectively, and distributes a certain bandwidth to users based on requirements of the user terminals. Then, the base station transmits uplink channel time slot distribution information and parameter information related to design of a prototype filter to all user terminals. In addition to a center frequency and a subband width, other parameters for design of the prototype filter are the same for all users.

Subsequently, in step 4, the user terminals optimize design of corresponding synthesis filters based on a received parameter optimizing instruction, to generate a synthesis filter bank, and transmit a training sequence to the base station end.

Technical effects of a non-perfect reconstruction filter bank system and subband signal detection method according to the embodiment of the present disclosure are described by several specific examples hereinafter.

First Example

The system has the following parameters. The number of subbands is M=8, an modulation mode is Quadrature Phase Shift Keying (QPSK), an impulse response of a prototype filter is $h_p(n)$, an overlap point of a spectrum of the impulse response and its neighboring spectrum is indicated as $\omega_s$, $\omega_s=\pi/2M$, a cut-off frequency point of a spectrum passband of the prototype filter is $\omega_1=0.4*\omega_s$, and a stopband cut-off frequency point is $\omega_2=0.6*\omega_s$. A synthesis filter $f_k(n)$ (k=0, 1, ..., M-1) and an analysis filter $h_k(n)$ (k=0, 1, ..., M-1) are obtained by performing spectrum shift on the prototype filter $h_p(n)$, specific expressions are given as follows:

$$f_k(n) = \sqrt{M} h_p(n) \exp[j\frac{2\pi}{M}(k+\frac{1}{2})(n+\frac{M+2}{4})], \quad n=0,1,...,N_f-1, \quad k=0,1,...,M-1,$$

$$h_k(n) = \sqrt{M} h_p(n) \exp[-j\frac{2\pi}{M}(k+\frac{1}{2})(N-n+\frac{M+2}{4})], \quad n=1,2,...,N_f, \quad k=0,1,...,M-1.$$

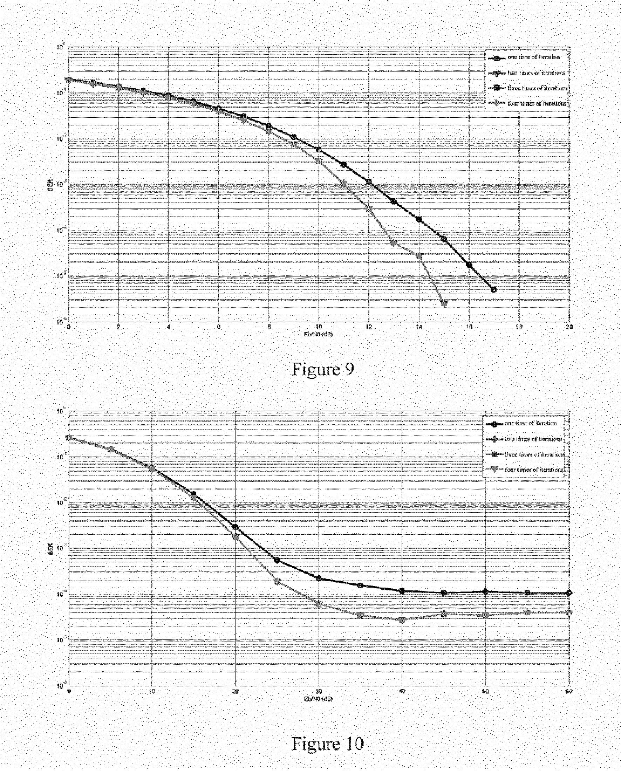

According to the filter bank designed based on the above expressions, an overlap point of neighboring subbands is approximately lower than a peak response by 19dB, a length of a filter is $N_f=8*M=64$, the number of times of iterations is Q=4, and a channel is an Addictive White Gaussian Noise (AWGN) channel. Figure 9 shows Bit Error Rate (BER) curves of a system in a corresponding condition when ZF is used, and the curves include four curves the number of times of iterations of which are 1 to 4 respectively (the curves are indicated as "one time of iteration", "two times of iterations", "three times of iterations" and "four times of iterations"). It may be seen from Figure 9 that, with increase of the number of times of iterations, the BER performances are tend to present a same curve, and no "Error Floor" effect occurs. Therefore, under the AWGN channel, with the method according to the present disclosure, a better bit error rate performance can be obtained without the great number of times of iterations, and two times of iterations are enough, thereby reducing complexity of a receiver.

Second Example

The system has the following parameters. The number of subbands is M=8, a modulation mode is QPSK, an impulse response of a prototype filter is indicated as $h_p(n)$, an overlap point of a spectrum of the impulse response and its neighboring spectrum is indicated as $\omega_s$, $\omega_s=\pi/2M$, a passband cut-off frequency point of the prototype filter is $\omega_1=0.4*\omega_s$, a stopband cut-off frequency point is $\omega_2=0.6*\omega_s$, and a synthesis filter $f_k(n)$ (k=0, 1, ..., M-1) and an analysis filter $h_k(n)$ (k=0, 1, ..., M-1) are obtained by spectrum shift by the prototype filter $h_p(n)$. Expressions of $f_k(n)$ and $h_k(n)$ are as follows:

$$f_k(n) = \sqrt{M} h_p(n) \exp[j\frac{2\pi}{M}(k+\frac{1}{2})(n+\frac{M+2}{4})], \quad n=0,1,...,N_f-1, \quad k=0,1,...,M-1,$$

$$h_k(n) = \sqrt{M} h_p(n) \exp[-j \frac{2\pi}{M}(k+\frac{1}{2})(N-n+\frac{M+2}{4})], \quad n = 1, 2, ..., N_f, \quad k = 0, 1, ..., M-1.$$

According to the filter bank designed based on the above expressions, an overlap point of neighboring subbands is approximately lower than a peak response by 19dB, a length of a filter is $N_f=8*M=64$, the number of times of iterations is Q=4, and a channel is a 12-tap Rayleigh fading channel. Figure 10 shows BER curves of a system in a corresponding condition when ZF is used, and the curves include four curves the number of times of iterations of which are 1 to 4 respectively (the curves are indicated as "one time of iteration", "two times of iterations", "three times of iterations" and "four times of iterations"). It may be seen from Figure 10 that, with increase of the number of times of iterations, the BER performances are tend to present a same curve. Therefore, under a multi-path channel, with the method according to the present disclosure, a better bit error rate performance can be obtained without the great number of times of iterations, and two times of iterations are enough. Figure 10 shows that an "Error Floor" effect exists for the bit error rate. However, the error floor bit error rate is less than 10^(-3), falling in a correction range of common Forward Error Code (FEC), therefore the error can be eliminated by channel encoding and decoding.

Third Example

The third example shows an optimal filter design. The system has the following parameters. The number of subbands is M=8, a length of the filter is $N_f=8*M=64$, and a modulation mode is QPSK. A prototype filter is designed by using the rule of Constrained-Least-Squares (CLS) in the example. A passband cut-off frequency $\omega_p$ and a stopband cut-off frequency $\omega_s$ ($\omega_p \leq \omega_s$) of a prototype filter are adjusted dynamically, such that a target function F = Blog$_2$(1 + SINR) is maximized. In which, B indicates a 3dB bandwidth of an equivalent impulse response $c_{k,k}(m)$, and

$$SINR = P_s \sum_m \left| c_{k,k}(m) \right|^2 / (P_s \sum_m \left| c_{k,k-1}(m) \right|^2 + P_s \sum_m \left| c_{k,k+1}(m) \right|^2 + \sigma_n^2 \sum_n \left| h_k(n) \right|^2)$$

indicates a signal-to-interference-plus-noise ratio of a k-th subband. $c_{k,k}(m)$ indicates an equivalent channel impulse response from a k-th input subband to a k-th output subband, where k may be any value of 1 to M. $c_{k,k-1}(m)$ indicates an equivalent channel impulse response from a (k-1)-th input subband to a k-th output subband. $c_{k,k+1}(m)$ indicates an equivalent channel impulse response from a (k+1)-th input subband to a k-th output subband, and $\sigma_n^2$ indicates a noise variance.

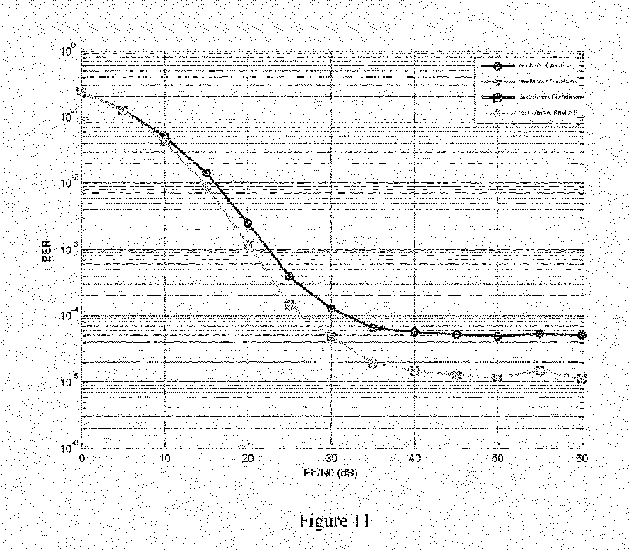

Figure 11 shows a curve of a bit error rate of a system when a signal-to-noise ratio is 30dB, optimized filter design is used and a channel is 12-tap Rayleigh fading channel. Comparing Figure 11 with Figure 10, it can be concluded that the BER performance in Figure 11 is better, which proves effectiveness of the optimizing method according to the present disclosure.

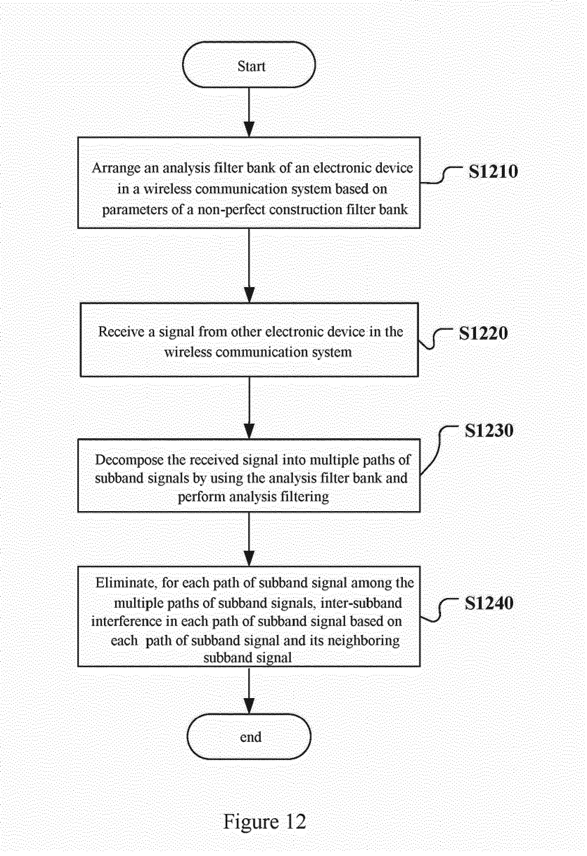

Hereinafter a method for performing wireless communication in a wireless communication system according to an embodiment of the present disclosure is described in conjunction with Figure 12.

As shown in Figure 12, in step S1210, an analysis filter bank of an electronic device in the wireless communication system is arranged based on parameters of a non-perfect reconstruction filter bank.

Subsequently, in step S1220, a signal from other electronic device in the wireless communication system is received.

Next, in step S1230, the received signal is decomposed into multiple paths of subband signals by using the analysis filter bank and analysis filtering is performed.

Lastly, in step S1240, for each path of subband signal among the multiple paths of subband signals, inter-subband interference in each path of subband signal is eliminated based on each path of subband signal and its neighboring subband signal.

According to the embodiment of the present disclosure, in step S1240, the inter-subband interference in each path of subband signal may be eliminated in an iterative manner.

Preferably, the eliminating inter-subband interference in each path of subband signal may include: initializing each path of estimated subband signal and the number of times of iterations; estimating an interference signal for each path of subband signal based on a neighboring subband signal of each path of subband signal estimated in a last time of iteration; estimating each path of subband signal after interference elimination based on the estimated interference signal for each path of subband signal; performing single-subband equalizing on each path of subband signal after interference eliminating, to obtain each path of equalized subband signal; performing hard decision on each path of equalized subband signal, to obtain each path of subband signal estimated in a current iteration; and terminating iterations when the number of times of iterations reaches a predetermined value.

Preferably, iterations may be terminated when the number of times of iterations reaches two.

According to the embodiment of the present disclosure, the outputted signal may be de-mapped to obtain an estimated bit stream.

According to the embodiment of the present disclosure, parameters of a non-perfect reconstruction filter bank may be configured based on a frequency band division requirement and/or a subband overlapping design requirement, and at least a part of the configured parameters of the non-perfect reconstruction filter bank may be transmitted to other electronic device in the wireless communication system.

According to the embodiment of the present disclosure, a signal containing response information may be received from other electronic device in the wireless communication system. The response information is information on an equivalent channel impulse response of each path of subband among multiple paths of subbands and an equivalent channel impulse response of a neighboring subband of each path of subband for each path of subband. Inter-subband interference in each path of subband signal may be eliminated based on each path of subband signal and its neighboring subband signal, by using the obtained equivalent channel impulse response of each path of subband among the multiple paths of subbands and equivalent channel impulse response of the neighboring subband of each path of subband for each path of subband.

According to the embodiment of the present disclosure, the configured parameters of the non-perfect reconstruction filter bank may include: the number of subbands, a length of a filter, a center frequency of a subband and a width of a subband. Preferably, the configured parameter of the non-perfect reconstruction filter bank may further include at least one of a transition band control factor, a ratio of a passband error to a stopband error, a passband offset, a stopband offset and an error tolerance.

Preferably, for each of the subbands, a passband cut-off frequency and a stopband cut-off frequency may be adjusted dynamically to maximize the following target function F:

$$F = B\log_2(1 + SINR).$$

In which, B indicates a width of an equivalent channel of each of the subbands, and SINR indicates a signal-to-interference-plus-noise ratio of each of the subbands.

According to the embodiment of the present disclosure, parameters of the non-perfect reconstruction filter bank may be configured, when a data transmission request from other electronic device in the wireless communication system is received or during data transmission with the other electronic device in the wireless communication system.

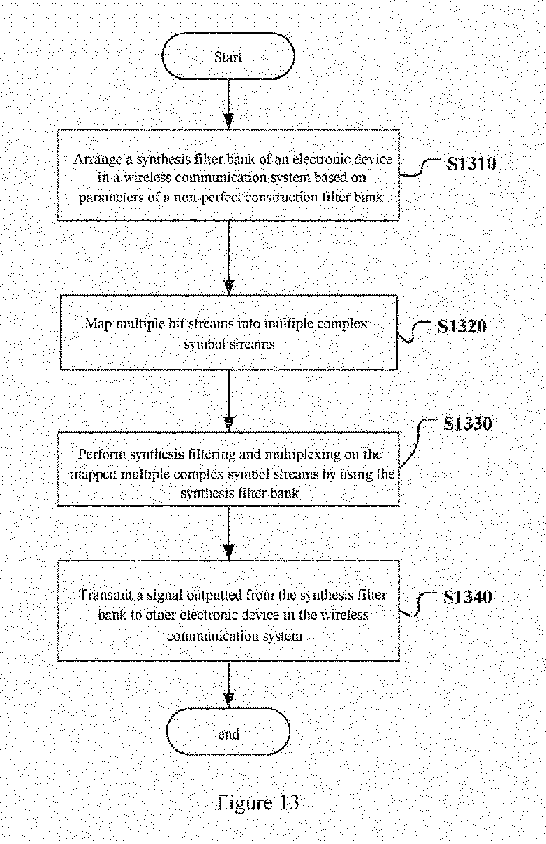

Hereinafter a method for performing wireless communication in a wireless communication system according to an embodiment of the present disclosure is described in conjunction with Figure 13.

As shown in Figure 13, in step S1310, a synthesis filter bank of an electronic device in the wireless communication system is arranged based on parameters of a non-perfect reconstruction filter bank.

Subsequently, in step S1320, multiple bit streams are mapped into multiple complex symbol streams.

Next, in step S1330, synthesis filtering and multiplexing are performed on the mapped multiple complex symbol streams by using the synthesis filter bank.

Lastly, in step S1340, a signal outputted from the synthesis filter bank is transmitted to the other electronic device in the wireless communication system.

According to the embodiment of the present disclosure, parameters of the non-perfect reconstruction filter bank may be received from the other electronic device in the wireless communication system.

According to the embodiment of the present disclosure, an equivalent channel impulse response of each path of subband among multiple paths of subbands and an equivalent channel impulse response of a neighboring subband of each path of subband for each path of subband are calculated by using the parameters of the non-perfect reconstruction filter bank, and a signal containing response information may be transmitted to other electronic device in the wireless communication system. The response information is information on the equivalent channel impulse response of each path of subband among the multiple paths of subbands and the equivalent channel impulse response of the neighboring subband of each path of subband for each path of subband.

Preferably, the bit stream may be a bit stream having been subjected to channel encoding or a bit stream having not been subjected to channel encoding.

Specific implementations of the steps of the method for performing wireless communication in the wireless communication system according to the embodiment of the present disclosure have been described in detail above, which are not repeated here.

According to the embodiment of the present disclosure, an electronic device is further provided. The electronic device includes a processing circuit, and the processing circuit is configured to: arrange an analysis filter bank of an electronic device in a wireless communication system based on parameters of a non-perfect reconstruction filter bank; receive a signal from other electronic device in the wireless communication system; decompose the received signal into multiple paths of subband signals by using the analysis filter bank and perform analysis filtering; and for each path of subband signal among the multiple paths of subband signals, eliminate inter-subband interference of each path of subband signal based on each path of subband signal and its neighboring subband signal.

According to an embodiment of the present disclosure, an electronic device may be further provided. The electronic device includes a processing circuit, and the processing circuit is configured to: arrange a synthesis filter bank of an electronic device in a wireless communication system based on parameters of a non-perfect reconstruction filter bank; map multiple bit streams into multiple complex symbol streams; perform synthesis filtering and multiplexing on the mapped multiple complex symbol streams by using the synthesis filter bank; and transmit a signal outputted from the synthesis filter bank to the other electronic device in the wireless communication system.

It should be understood that, the electronic device described above may perform other technical solutions of the present disclosure, which are not described in detail one by one for briefness.

Obviously, operation steps of the method for performing wireless communication in the wireless communication system according to the present disclosure may be implemented by computer executable programs stored in various types of machine readable storage mediums.

And, the object of the present disclosure can be implemented in a manner that the storage medium on which the computer executable program codes above are carried is provided directly or indirectly to a system or apparatus, a computer or a Central Processing Unit (CPU) of which reads out and executes the computer executable program. Here, the implementation of the present disclosure is not limited to a program as long as the system or apparatus has a function to execute the program, and the program can be in arbitrary forms such as an objective program, a program executed by an interpreter, a script program provided to an operating system, etc.

The machine-readable storage medium mentioned above includes, but is not limited to, various memories and storage units, a semiconductor device, a disk unit such as an optic disk, a magnetic disk and a magneto-optic disk, and other medium suitable for storing information.

Additionally, the present disclosure can also be implemented by connecting to a corresponding web site on the Internet through a computer, downloading and installing the computer program codes according to the present disclosure into the computer, and then executing the program, and the technical solution of the present disclosure can be implemented.

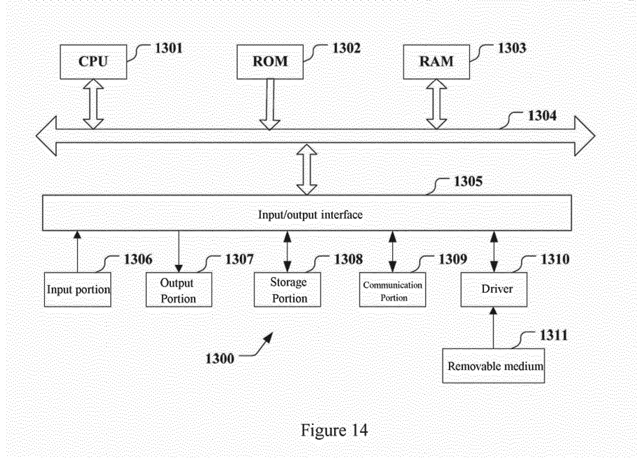

Figure 14 is a block diagram illustrating an exemplary structure of a general-purpose personal computer on which the method for performing wireless communication in a wireless communication system according to the embodiments of the present disclosure can be implemented.

As shown in Figure 14, a CPU 1301 executes various processing according to a program stored in a Read Only Memory (ROM) 1302 or a program loaded to a Random Access Memory (RAM) 1303 from a storage portion 1308. In the RAM 1303, if necessary, data required for the CPU 1301 in executing various processing and the like is also stored. The CPU 1301, the ROM 1302 and the RAM 1303 are connected to each other via a bus 1304. An input/output interface 1305 is also connected to the bus 1304.

The following components are connected to the input/output interface 1305: an input portion 1306 including a keyboard, a mouse and the like, an output portion 1307 including a display such as a Cathode Ray Tube (CRT) and a Liquid Crystal Display (LCD), a speaker and the like, the storage portion 1308 including a hard disk and the like, and a communication portion 1309 including a network interface card such as a LAN card, a modem and the like. The communication portion 1309 performs communication processing via a network such as the Internet. If necessary, a driver 1310 can also be connected to the input/output interface 1305. A removable medium 1311 such as a magnetic disk, an optical disk, a magneto-optical disk, a semiconductor memory and the like is mounted on the driver 1310 as necessary such that a computer program read out therefrom is installed in the storage portion 1308.

In a case that the series of processing above is implemented in software, a program constituting the software is installed from the network such as the Internet or the storage medium such as the removable medium 1311.

It is understood by those skilled in the art that the storage medium is not limited to the removable medium 1311 shown in Figure 9 in which the program is stored and which is distributed separately from the device so as to provide the program to the user. Examples of the removable medium 1311 include a magnetic disk including a Floppy Disk (registered trademark), an optical disk including a Compact Disk Read Only Memory (CD-ROM) and a Digital Versatile Disc (DVD), a magneto-optical disk including a MiniDisc (MD) (registered trademark), and a semiconductor memory. Alternatively, the storage medium may be the ROM 1302, the hard disk contained in the storage portion 1308 or the like. Herein, the program is stored in the storage medium, and the storage medium is distributed to the user together with the device containing the storage medium.

As described above, a communication system based on a non-perfect reconstruction filter bank and subband signal detection method thereof are provided according to the present disclosure. With the non-perfect reconstruction filter bank system according to the present disclosure, a filter can be designed by any method without strictly following the conventional perfect reconstruction characteristic, as long as the filer can meet a frequency band dividing requirement for an actual application, thereby improving flexibility of the existing system. A subband signal detection method adapting for the communication system is further provided according to the present disclosure.

As compared with the existing filter bank system, with the non-perfect reconstruction filter bank system and a transmitting and receiving end algorithm thereof according to the present disclosure, a signal allowed to be inputted is a complex signal without being subjected to any pre-processing, such that the transmitting end is simpler and it is easy to process the signal. In addition, with the optimizing prototype filter design method according to the present disclosure, an optimum prototype filter can be obtained by comprehensively considering the signal-to-interference-plus-noise ratio and the effective bandwidth of the equivalent channel. As compared with the non-optimum design, a good communication effect can be obtained.

In the system and method of the present disclosure, it is obvious that respective components or steps can be decomposed and/or recombined. Such decomposition and/or recombination should be considered as an equivalent solution of the present disclosure. And, the steps performing a series of processing above can be performed in the describing order naturally, but this is not necessary. Some steps can be performed concurrently or independently with one another.

Although the embodiments of the present disclosure have been described in detail in combination with the drawings above, it should be understood that, the embodiments described above are only used to explain the invention and are not constructed as the limitation to the present disclosure. For those skilled in the art, various modifications and alternations can be made to the above embodiments without departing from the scope of the appended claims.

## Claims

1. An electronic device (100) in a wireless communication system, comprising circuitry (110, 120, 130, 150, 160), configured to:

   receive a signal from other electronic device in the wireless communication system;
   arrange an analysis filter bank based on parameters of a Non-Perfect Reconstruction filter bank, decompose the received signal into multiple paths of subband signals using the analysis filter bank and perform analysis filtering; and
   eliminate, for each path of subband signal among the multiple paths of subband signals, inter-subband interference in each path of subband signal, based on each path of subband signal and its neighboring subband signals;
   wherein the circuitry is configured to:

   configure the parameters of the Non-Perfect Reconstruction filter bank based on a frequency band division requirement and/or a subband overlapping design requirement; and
   transmit at least a part of the parameters of the Non-Perfect Reconstruction filter bank to the other electronic device in the wireless communication system.

2. The electronic device according to claim 1, wherein the circuitry is configured to eliminate the inter-subband interference in each path of subband signal in an iterative manner.

3. The electronic device according to claim 2, wherein the circuitry is configured to:

   initialize each path of estimated subband signal and the number of times of iterations;
   estimate, based on a neighboring subband signal of each path of subband signal estimated during a last time of iteration, an interference signal for each path of subband signal;
   estimate, based on the interference signal for each path of subband signal estimated, each path of subband signal after interference elimination;
   perform single-subband equalization on each path of subband signal after interference elimination to obtain each path of equalized subband signal;
   perform hard decision on each path of equalized subband signal to obtain each path of subband signal estimated during a current time of iteration; and
   terminate iterations when the number of times of iterations reaches a predetermined value.

4. The electronic device according to claim 3, wherein the circuitry is configured to terminate the iterations when the number of times of iterations reaches two.

5. The electronic device according to claim 1, the circuitry is configured to:

de-map a signal after eliminating inter-subband interference to obtain an estimated bit stream.

6. The electronic device according to claim 1, wherein the circuitry is configured to:

   receive a signal containing response information from the other electronic device in the wireless communication system, the response information being information on an equivalent channel impulse response of each path of subband among multiple paths of subbands and an equivalent channel impulse response of a neighboring subband of each path of subband for each path of subband; and
   eliminate the inter-subband interference in each path of subband signal, based on each path of subband signal and its neighboring subband signal, using the equivalent channel impulse response of each path of subband among the multiple paths of subbands and the equivalent channel impulse response of the neighboring subband of each path of subband for each path of subband.

7. The electronic device according to claim 1, wherein the parameters of the Non-Perfect Reconstruction filter bank configured by the circuitry comprise the number of subbands, a length of a filter, a center frequency of a subband and a bandwidth of a subband.

8. The electronic device according to claim 7, wherein the parameters of the Non-Perfect Reconstruction filter bank configured by the circuitry further comprise at least one of a transition band control factor, a ratio of a passband error to a stopband error, a passband offset, a stopband offset and an error tolerance.

9. The electronic device according to claim 1, wherein when the circuitry receives a data transmission request from the other electronic device in the wireless communication system, or during data transmission performed by the electronic device with the other electronic device in the wireless communication system, the circuitry is configured to configure the parameters of the Non-Perfect Reconstruction filter bank.

10. The electronic device according to claim 1, wherein in a case that a synthesis filter bank and an analysis filter bank are not combined to carry out design to satisfy a perfect reconfiguration characteristic, the circuitry is configured to configure the parameters of the Non-Perfect Reconstruction filter bank.

11. An electronic device (300) in a wireless communication system, comprising circuitry (310, 320, 330, 340), configured to:

   map a plurality of bit streams into a plurality of complex symbol streams;
   arrange a synthesis filter bank based on parameters of a Non-Perfect Reconstruction filter bank and perform synthesis filtering and multiplexing on the mapped plurality of complex symbol streams using the synthesis filter bank; and
   transmit a signal outputted from the synthesis filter bank to other electronic device in the wireless communication system;
   wherein the circuitry is configured to:
   receive the parameters of the Non-Perfect Reconstruction filter bank from the other electronic device in the wireless communication system.

12. The electronic device according to claim 11, the circuitry is configured to:

   calculate, using the parameters of the Non-Perfect Reconstruction filter bank, an equivalent channel impulse response of each path of subband among multiple paths of subbands and an equivalent channel impulse response of a neighboring suband of each path of subband for each path of subband, and
   wherein the circuitry is configured to transmit a signal containing response information to the other electronic device in the wireless communication system, the response information being information on the equivalent channel impulse response of each path of subband among the multiple paths of subbands and the equivalent channel impulse response of the neighboring suband of each path of subband for each path of subband.

**Patentansprüche**

1. Elektronische Vorrichtung (100) in einem Drahtloskommunikationssystem, umfassend Schaltungsanordnung (110, 120, 130, 150, 160), die für Folgendes ausgelegt ist:

Empfangen eines Signals von einer anderen elektronischen Vorrichtung im Drahtloskommunikationssystem;
Anordnen einer Analysefilterbank auf der Grundlage von Parametern einer Filterbank für nicht-perfekte Rekonstruktion (engl. Non-Perfect Reconstruction),
Zerlegen des empfangenen Signals in mehrere Pfade von Teilbandsignalen unter Verwendung der Analysefilterbank und Durchführen von Analysefilterung; und
Beseitigen, für jeden Teilbandsignalpfad unter den mehreren Pfaden von Teilbandsignalen, von Inter-Teilbandstörungen in jedem Teilbandsignalpfad, auf der Grundlage jedes Teilbandsignalpfads und seiner benachbarten Teilbandsignale;
wobei die Schaltungsanordnung für Folgendes ausgelegt ist:

Auslegen der Parameter der Filterbank für nicht-perfekte Rekonstruktion auf der Grundlage einer Frequenzbandaufteilungsanforderung und/oder einer Teilbandüberlappungsanforderung; und
Übertragen zumindest eines Teil der Parameter der Filterbank für nicht-perfekte Rekonstruktion an die andere elektronische Vorrichtung im Drahtloskommunikationssystem.

2. Elektronische Vorrichtung nach Anspruch 1, wobei die Schaltungsanordnung dafür ausgelegt ist, die Inter-Teilbandstörungen in jedem Teilbandsignalpfad in einer iterativen Weise zu beseitigen.

3. Elektronische Vorrichtung nach Anspruch 2, wobei die Schaltungsanordnung für Folgendes ausgelegt ist:

Initialisieren jedes Pfad von geschätztem Teilbandsignal und der Anzahl der Iterationen;
Schätzen, auf der Grundlage eines benachbarten Teilbandsignals jedes Teilbandsignalpfads, der während eines letzten Iterationszeitpunkts geschätzt wurde, eines Störungssignals für jeden Teilbandsignalpfad;
Schätzen, basierend auf dem Störungssignal für jeden geschätzten Teilbandsignalpfad, jedes Teilbandsignalpfads nach Störungsbeseitigung;
Durchführen von Einzelteilbandentzerrung auf jedem Teilbandsignalpfad nach Störungsbeseitigung, zum Erhalten jedes Pfads von entzerrtem Teilbandsignal;
Durchführen von Hartentscheidung auf jedem Pfad von entzerrtem Teilbandsignal, zum Erhalten jedes Teilbandsignalpfads, der während eines aktuellen Iterationszeitpunkts geschätzt wird; und
Beenden der Iterationen, wenn die Anzahl von Iterationen einen vorbestimmten Wert erreicht.

4. Elektronische Vorrichtung nach Anspruch 3, wobei die Schaltungsanordnung dafür ausgelegt ist, die Iterationen zu beenden, wenn die Anzahl von Iterationen zwei erreicht.

5. Elektronische Vorrichtung nach Anspruch 1, wobei die Schaltungsanordnung für Folgendes ausgelegt ist:
De-Mapping eines Signals nach dem Beseitigen von Inter-Teilbandstörungen, zum Erhalten eines geschätzten Bitstroms.

6. Elektronische Vorrichtung nach Anspruch 1, wobei die Schaltungsanordnung für Folgendes ausgelegt ist:

Empfangen eines Signals, das Antwortinformationen von der anderen elektronischen Vorrichtung im Drahtloskommunikationssystem enthält, wobei die Antwortinformationen Informationen über eine äquivalente Kanalimpulsantwort jedes Teilbandpfads unter mehreren Pfaden von Teilbändern und eine äquivalente Kanalimpulsantwort eines benachbarten Teilbands jedes Teilbandpfads für jeden Teilbandpfad sind; und
Beseitigen der Inter-Teilbandstörungen in jedem Teilbandsignalpfad auf der Grundlage jedes Teilbandsignalpfads und seines benachbarten Teilbandsignals, unter Verwendung der äquivalenten Kanalimpulsantwort jedes Teilbandpfads unter den mehreren Pfaden von Teilbändern und der äquivalenten Kanalimpulsantwort des benachbarten Teilbands jedes Teilbandpfads für jeden Teilbandpfad.

7. Elektronische Vorrichtung nach Anspruch 1, wobei die Parameter der durch die Schaltungsanordnung ausgelegten Filterbank für nicht-perfekte Rekonstruktion die Anzahl von Teilbändern, eine Länge eines Filters, eine Mittenfrequenz eines Teilbands und eine Bandbreite eines Teilbands umfassen.

8. Elektronische Vorrichtung nach Anspruch 7, wobei die Parameter der durch die Schaltungsanordnung ausgelegten Filterbank für nicht-perfekte Rekonstruktion ferner mindestens eines von einem Übergangsbandsteuerfaktor, einem Verhältnis eines Durchlassbereichsfehlers zu einem Sperrbereichsfehler, einem Durchlassbereichsversatz, einem Sperrbereichsversatz und einer Fehlertoleranz umfassen.

**9.** Elektronische Vorrichtung nach Anspruch 1, wobei, wenn die Schaltungsanordnung eine Datenübertragungsanforderung von der anderen elektronischen Vorrichtung im Drahtloskommunikationssystem empfängt, oder während Datenübertragung durch die elektronische Vorrichtung mit der anderen elektronischen Vorrichtung im Drahtloskommunikationssystem durchgeführt wird, die Schaltungsanordnung dafür ausgelegt ist, die Parameter der Filterbank für nicht-perfekte Rekonstruktion auszulegen.

**10.** Elektronische Vorrichtung nach Anspruch 1, wobei in einem Fall, in dem eine Synthesefilterbank und eine Analysefilterbank nicht zum Erfüllen einer perfekten Rekonfigurationscharakteristik kombiniert werden, die Schaltungsanordnung dafür ausgelegt ist, die Parameter der Filterbank für nicht-perfekte Rekonstruktion auszulegen.

**11.** Elektronische Vorrichtung (300) in einem Drahtloskommunikationssystem, umfassend eine Schaltungsanordnung (310, 320, 330, 340), die für Folgendes ausgelegt ist:

Abbilden einer Vielzahl von Bitströmen in eine Vielzahl von komplexen Symbolströmen;
Anordnen einer Synthesefilterbank auf der Grundlage von Parametern einer Filterbank für nicht-perfekte Rekonstruktion und Durchführen von Synthesefilterung und Multiplexing auf der abgebildeten Vielzahl von komplexen Symbolströmen unter Verwendung der Synthesefilterbank; und
Übertragen eines von der Synthesefilterbank ausgegebenen Signals an die andere elektronische Vorrichtung im Drahtloskommunikationssystem;
wobei die Schaltungsanordnung für Folgendes ausgelegt ist:
Empfangen der Parameter der Filterbank für nicht-perfekte Rekonstruktion von der anderen elektronischen Vorrichtung im Drahtloskommunikationssystem.

**12.** Elektronische Vorrichtung nach Anspruch 11, wobei die Schaltungsanordnung für Folgendes ausgelegt ist:

Berechnen, unter Verwendung der Parameter der Filterbank für nicht-perfekte Rekonstruktion, einer äquivalenten Kanalimpulsantwort jedes Teilbandpfads unter mehreren Pfaden von Teilbändern und einer äquivalenten Kanalimpulsantwort eines benachbarten Teilbands jedes Teilbandpfads für jeden Teilbandpfad, und
wobei die Schaltungsanordnung dafür ausgelegt ist, ein Signal mit Antwortinformationen an die andere elektronische Vorrichtung im Drahtloskommunikationssystem zu übertragen, wobei die Antwortinformationen Informationen über die äquivalente Kanalimpulsantwort jedes Teilbandpfads unter den mehreren Pfaden von Teilbändern und die äquivalente Kanalimpulsantwort des benachbarten Teilbands jedes Teilbandpfads für jeden Teilbandpfad sind.

**Revendications**

**1.** Dispositif électronique (100) dans un système de communication sans fil, comprenant un ensemble de circuits (110, 120, 130, 150, 160), conçu pour :

recevoir un signal en provenance d'un autre dispositif électronique dans le système de communication sans fil ;
agencer un banc de filtres d'analyse sur la base de paramètres d'un banc de filtres à reconstruction non parfaite, décomposer le signal reçu en de multiples trajets de signaux de sous-bande à l'aide du banc de filtres d'analyse et réaliser un filtrage d'analyse ; et
éliminer, pour chaque trajet de signal de sous-bande parmi les multiples trajets de signaux de sous-bande, une interférence inter-sous-bande dans chaque trajet de signal de sous-bande, sur la base de chaque trajet de signal de sous-bande et ses signaux de sous-bande voisins ;
dans lequel l'ensemble de circuits est conçu pour :

configurer les paramètres du banc de filtres à reconstruction non parfaite sur la base d'une exigence de division de bande de fréquence et/ou d'une exigence de conception de chevauchement de sous-bande ; et
émettre au moins une partie des paramètres du banc de filtres à reconstruction non parfaite vers l'autre dispositif électronique dans le système de communication sans fil.

**2.** Dispositif électronique selon la revendication 1, dans lequel l'ensemble de circuits est conçu pour éliminer une interférence inter-sous-bande dans chaque trajet de signal de sous-bande d'une manière itérative.

**3.** Dispositif électronique selon la revendication 2, dans lequel l'ensemble de circuits est conçu pour :

initialiser chaque trajet de signal de sous-bande estimé et le nombre d'itérations ;

estimer, sur la base d'un signal de sous-bande voisin de chaque trajet de signal de sous-bande estimé pendant une dernière itération, un signal d'interférence pour chaque trajet de signal de sous-bande ;

estimer, sur la base du signal d'interférence pour chaque trajet de signal de sous-bande estimé, chaque trajet de signal de sous-bande après une élimination d'interférence ;

réaliser une égalisation de sous-bande unique sur chaque trajet de signal de sous-bande après l'élimination de l'interférence afin d'obtenir chaque trajet de signal de sous-bande égalisé ;

réaliser une décision ferme sur chaque trajet de signal de sous-bande égalisé afin d'obtenir chaque trajet de signal de sous-bande estimé pendant une itération en cours ; et

mettre fin aux itérations lorsque le nombre d'itérations atteint une valeur prédéfinie.

4. Dispositif électronique selon la revendication 3, dans lequel l'ensemble de circuits est conçu pour mettre fin aux itérations lorsque le nombre d'itérations atteint deux.

5. Dispositif électronique selon la revendication 1, l'ensemble de circuits étant conçu pour :
démapper un signal après l'élimination de l'interférence inter-sous-bande afin d'obtenir un flux binaire estimé.

6. Dispositif électronique selon la revendication 1, dans lequel l'ensemble de circuits est conçu pour :

recevoir un signal contenant des informations de réponse en provenance de l'autre dispositif électronique dans le système de communication sans fil, les informations de réponse étant des informations sur une réponse d'impulsion de canal équivalente de chaque trajet de sous-bande parmi de multiples trajets de sous-bandes et sur une réponse d'impulsion de canal équivalente d'une sous-bande voisine de chaque trajet de sous-bande pour chaque trajet de sous-bande ; et

éliminer l'interférence inter-sous-bande dans chaque trajet de signal de sous-bande, sur la base de chaque trajet de signal de sous-bande et de son signal de sous-bande voisin, à l'aide de la réponse d'impulsion de canal équivalente de chaque trajet de sous-bande parmi les multiples trajets de sous-bandes et de la réponse d'impulsion de canal équivalente de la sous-bande voisine de chaque trajet de sous-bande pour chaque trajet de sous-bande.

7. Dispositif électronique selon la revendication 1, dans lequel les paramètres du banc de filtres à reconstruction non parfaite configuré par l'ensemble de circuits comprennent le nombre de sous-bandes, une longueur d'un filtre, une fréquence centrale d'une sous-bande et une largeur de bande d'une sous-bande.

8. Dispositif électronique selon la revendication 7, dans lequel les paramètres du banc de filtres à reconstruction non parfaite configuré par l'ensemble de circuits comprennent en outre au moins un parmi un facteur de commande de bande de transition, un rapport d'une erreur de bande passante à une erreur de bande affaiblie, un décalage de bande passante, un décalage de bande affaiblie et une tolérance d'erreur.

9. Dispositif électronique selon la revendication 1, dans lequel lorsque l'ensemble de circuits reçoit une requête d'émission de données en provenance de l'autre dispositif électronique dans le système de communication sans fil, ou pendant une émission de données effectuée par le dispositif électronique avec l'autre dispositif électronique dans le système de communication sans fil, l'ensemble de circuits est conçu pour configurer les paramètres du banc de filtres à reconstruction non parfaite.

10. Dispositif électronique selon la revendication 1, dans lequel, dans un cas où un banc de filtres de synthèse et un banc de filtres d'analyse ne sont pas combinés pour réaliser une conception pour satisfaire une caractéristique de reconfiguration parfaite, l'ensemble de circuits est conçu pour configurer les paramètres du banc de filtres à reconstruction non parfaite.

11. Dispositif électronique (300) dans un système de communication sans fil, comprenant
un ensemble de circuits (310, 320, 330, 340), conçu pour :

mapper une pluralité de flux binaires en une pluralité de flux de symboles complexes ;

agencer un banc de filtres de synthèse sur la base de paramètres d'un banc de filtres à reconstruction non parfaite et réaliser un filtrage de synthèse et un multiplexage sur la pluralité mappée de flux de symboles complexes à l'aide du banc de filtres de synthèse ; et

émettre un signal sorti du banc de filtres de synthèse vers l'autre dispositif électronique dans le système de communication sans fil ;

dans lequel l'ensemble de circuits est conçu pour :

recevoir les paramètres du banc de filtres à reconstruction non parfaite en provenance de l'autre dispositif électronique dans le système de communication sans fil.

12. Dispositif électronique selon la revendication 11, l'ensemble de circuits étant conçu pour :

calculer, à l'aide des paramètres du banc de filtres à reconstruction non parfaite, une réponse d'impulsion de canal équivalente de chaque trajet de sous-bande parmi de multiples trajets de sous-bandes et une réponse d'impulsion de canal équivalente d'une sous-bande voisine de chaque trajet de sous-bande pour chaque trajet de sous-bande, et

dans lequel l'ensemble de circuits est conçu pour émettre un signal contenant des informations de réponse vers l'autre dispositif électronique dans le système de communication sans fil, les informations de réponse étant des informations sur la réponse d'impulsion de canal équivalente de chaque trajet de sous-bande parmi les multiples trajets de sous-bandes et sur la réponse d'impulsion de canal équivalente de la sous-bande voisine de chaque trajet de sous-bande pour chaque trajet de sous-bande.

Figure 1

Figure 2

Figure 3

Figure 4(a)

Figure 4(b)

Figure 5

Figure 6

Figure 7

Figure 8

Figure 9

Figure 10

Figure 11

```
                    ┌─────────────┐
                    │    Start    │
                    └──────┬──────┘
                           │
                           ▼
        ┌──────────────────────────────────────┐
        │ Arrange an analysis filter bank of an │ ⌐ S1210
        │ electronic device in a wireless       │
        │ communication system based on         │
        │ parameters of a non-perfect           │
        │ construction filter bank              │
        └──────────────────┬───────────────────┘
                           │
                           ▼
        ┌──────────────────────────────────────┐
        │ Receive a signal from other           │ ⌐ S1220
        │ electronic device in the              │
        │ wireless communication system         │
        └──────────────────┬───────────────────┘
                           │
                           ▼                       ⌐ S1230
        ┌──────────────────────────────────────┐
        │ Decompose the received signal into    │
        │ multiple paths of subband signals by  │
        │ using the analysis filter bank and    │
        │ perform analysis filtering            │
        └──────────────────┬───────────────────┘
                           │
                           ▼
        ┌──────────────────────────────────────┐
        │ Eliminate, for each path of subband   │ ⌐ S1240
        │ signal among the multiple paths of    │
        │ subband signals, inter-subband        │
        │ interference in each path of subband  │
        │ signal based on each path of subband  │
        │ signal and its neighboring            │
        │ subband signal                        │
        └──────────────────┬───────────────────┘
                           │
                           ▼
                    ┌─────────────┐
                    │     end     │
                    └─────────────┘
```

Figure 12

Start

Arrange a synthesis filter bank of an electronic device in a wireless communication system based on parameters of a non-perfect construction filter bank — S1310

Map multiple bit streams into multiple complex symbol streams — S1320

S1330 — Perform synthesis filtering and multiplexing on the mapped multiple complex symbol streams by using the synthesis filter bank

Transmit a signal outputted from the synthesis filter bank to other electronic device in the wireless communication system — S1340

end

Figure 13

Figure 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- FBMC and GFDM Interference Cancellation Schemes for Flexible Digital Radio PHY Design. **ROHIT DATTA et al.** DIGITAL SYSTEM DESIGN (DSD), 2011, 14th EUROMAICRO CONFERENCE ON. IEEE, 31 August 2011, 335-339
- Uplink Multiple Access Aspect of DFF LTE. **RITT.** 3GPP DRAFT; R1-050402, 3RD GENERATION PARTNERSHIP PROJECT (3GPP). MOBILE COMPETENCE CENTRE, 03 May 2005
- Joint Channel and Frequency Offset Estimation for Oversampled Perfect Reconstruction Fitler Bank Transceivers. **RAHIMI SIAVASH et al.** IEEE TRANSACTIONS ON COMMUNICATOIN. IEEE SERVICE CENTRER, 01 June 2014, vol. 62, 2009-2021